# DEMANDE DE BREVET EUROPEEN

(11) **EP 4 357 988 A1**
(43) Date de publication de la demande: **24.04.2024**
(21) Numéro de dépôt: 23202771.4
(22) Date de dépôt: 10.10.2023
(51) Int. Cl.: G06Q 10/04, G06Q 50/06

(54) **PROCÉDÉS DE GESTION DE L'ÉNERGIE D'AU MOINS UN ÉQUIPEMENT, DISPOSITIFS ÉLECTRONIQUES ET PRODUITS PROGRAMMES D'ORDINATEUR CORRESPONDANTS**

(30) Priorité: 17.10.2022 FR 2210706
(71) Demandeur: Orange, 92130 Issy-les-Moulineaux (FR)
(72) Inventeur: HAMMEDI, Wided, 92326 Chatillon (FR); EXCOFFIER, David, 92326 Chatillon (FR); ROUDET, Franck, 92326 CHATILLON (FR)

(57) **Abrégé**

L'invention concerne un procédé de surveillance de l'énergie d'un équipement, comprenant :
- une obtention d'un premier modèle de prédiction d'énergie, et d'une fréquence ou d'un pas de mesure d'énergie ;
- une prédiction d'énergie, via ledit modèle de prédiction, en utilisant en entrée du modèle le résultat d'une première mesure d'énergie et des données contextuelles de l'équipement lors de et/ou depuis la première mesure, ladite prédiction étant effectuée avant et/ou lors d'une seconde mesure ultérieure à ladite première mesure et effectuée avec la fréquence et/ou le pas de mesure obtenu, par rapport à ladite première mesure;
- une variation de la fréquence et/ou du pas de mesure pour une troisième mesure ultérieure d'énergie, en fonction d'un écart entre l'énergie prédite et la seconde mesure.

L'invention concerne aussi un procédé de construction du premier modèle de prédiction d'énergie, et les dispositifs électroniques, système, produits programme d'ordinateur et support d'enregistrement correspondants.

## Description

### 1. Domaine technique

La présente application se rapporte au domaine général de la gestion de l'énergie d'équipements électroniques et/ou électromécaniques, par exemple des équipements, fixes ou mobiles appartenant à des systèmes industriels ou à l'internet des objets, localisés en intérieur ou à l'extérieur.

Par « gestion » de l'énergie, on entend ici le contrôle de l'énergie disponible à un tel équipement, ainsi que les apports et/ou la consommation en énergie de cet équipement.

Elle concerne notamment un procédé de surveillance de l'énergie d'au moins un équipement électromécanique, et un procédé de construction d'un modèle de prédiction de l'énergie d'au moins un équipement, ainsi que les dispositifs électroniques adaptés à la mise en oeuvre de tels procédés, et les produits programmes d'ordinateur et supports d'enregistrement correspondants.

### 2. Etat de la technique

Des équipements consommateurs d'énergie sont présents dans beaucoup de nos environnements. Ainsi, si les équipements électromécaniques sont beaucoup utilisés dans l'industrie, les objets communicants (dits aussi objets connectés) ont aujourd'hui envahi tous les domaines d'activité, tant professionnels ou privés.

Ces équipements peuvent être utilisés pour effectuer des tâches très variées, plus ou moins critiques, et plus ou moins consommatrices en termes d'énergie. Certains peuvent avoir un fonctionnement plus ou moins constant, d'autres un fonctionnement beaucoup plus irrégulier. Par exemple, un objet communicant peut être utilisé pour effectuer des opérations cryptographiques ponctuelles ou pour relayer régulièrement des mesures délivrées par un capteur.

De plus, certains de ces équipements peuvent bénéficier de ressources énergétiques importantes (par exemple parce qu'ils sont alimentés par le secteur ou par une batterie de grande capacité), tandis que d'autres équipements possèdent eux une autonomie énergétique particulièrement réduite. Cela peut notamment être le cas d'équipements alimentés au moins partiellement par une ou plusieurs sources d'énergie renouvelables (par exemple par énergie photovoltaïque via un couplage à des panneaux solaires. La captation d'énergie par un tel équipement peut varier selon son environnement, et/ou selon le moment de la captation d'énergie par exemple.

Du fait de tous ces facteurs, la consommation énergétique d'un équipement peut parfois varier fortement dans le temps. Connaître le niveau d'énergie courant d'un équipement peut s'avérer nécessaire, ou au moins intéressant, pour prévoir ses actions, ou lui apporter une énergie complémentaire si nécessaire (par exemple programmer une action de recharge d'une batterie).

Cependant, mesurer le niveau d'énergie d'un équipement électronique peut impliquer une consommation d'énergie importante, voire supérieure à l'énergie consommée par cet équipement pour exécuter certaines de ses tâches.

La présente demande a pour objet de proposer des améliorations à au moins certains des inconvénients de l'état de la technique.

### 3. Exposé de l'invention

La présente demande vise à améliorer la situation à l'aide notamment d'un procédé .. de surveillance de l'énergie (par exemple de l'énergie électrique) d'au moins un équipement et/ou d'un procédé de construction d'un modèle de prédiction d'une telle énergie.

La présente demande concerne ainsi un procédé de construction d'un modèle de prédiction de l'énergie courante d'un équipement électromécanique, ledit procédé comprenant :
- une construction d'une pluralité de modèles de prédiction à partir d'un modèle de prédiction initial, ladite pluralité de modèles de prédiction étant obtenue par une pluralité d'entraînements dudit modèle de prédiction initial, tenant compte d'un historique de résultats de mesure de l'énergie courante dudit équipement associés à des données représentatives d'un contexte dudit équipement entre lesdites et /ou lors desdites mesures, lesdites mesures étant effectuées avec des fréquences ou des pas de mesure différents dans ladite pluralité d'entraînements ;
- une sélection d'un des modèles construits en tenant compte desdits fréquences et/ou pas de mesure et de précisions desdits modèles construits.

Par contexte, on entend ici par exemple, comme détaillé plus loin, un environnement physique de l'équipement et/ou les activités de cet équipement.

Dans au moins certains modes de réalisation, le procédé de construction comprend une transmission à au moins un dispositif de données caractérisant ledit modèle de prédiction sélectionné, et/ou de la fréquence et/ou du pas de mesures utilisé pour l'entraînement dudit modèle de prédiction sélectionné.

Dans au moins certains modes de réalisation, le procédé de construction comprend une transmission audit dispositif d'au moins une indication relative à au moins un type de données contextuelles utilisées pour l'entraînement dudit modèle de prédiction sélectionné.

La présente demande concerne aussi un procédé de surveillance de l'énergie courante d'un équipement électromécanique, ledit procédé comprenant :
- une obtention d'un premier modèle de prédiction de ladite énergie courante dudit équipement, et/ou d'une fréquence de mesure et/ou d'un pas de mesure de ladite énergie ;
- une prédiction, via ledit modèle de prédiction, de l'énergie dudit équipement, en utilisant en entrée dudit modèle le résultat d'une première mesure de ladite énergie courante dudit équipement et des données représentatives d'un contexte dudit équipement lors de et/ou depuis la première mesure, ladite prédiction étant effectuée avant et/ou lors d'une seconde mesure ultérieure à ladite première mesure et effectuée en respectant ladite fréquence et/ou ledit pas de mesure obtenu par rapport à ladite première mesure;
- une variation de la fréquence et/ou du pas de mesure d'au moins une mesure de l'énergie dudit équipement, ultérieure à ladite seconde mesure, en fonction d'un écart entre ladite énergie prédite et ladite seconde mesure.

Dans au moins certains modes de réalisation, le procédé de surveillance comprend une obtention d'au moins une indication relative à au moins un type de données contextuelles à utiliser pour ledit modèle de prédiction ; et ladite obtention de données contextuelles tient compte de ladite indication obtenue.

Dans au moins certains modes de réalisation, l'obtention dudit modèle de prédiction, de ladite fréquence et/ou dudit pas de mesure comprend:
- une construction d'une pluralité de modèles de prédiction à partir d'un modèle de prédiction initial, ladite pluralité de modèles de prédiction étant obtenue par une pluralité d'entraînements dudit modèle de prédiction initial tenant compte d'un historique de résultats de mesure de l'énergie courante dudit équipement associés à des données représentatives d'un contexte dudit équipement entre lesdites et /ou lors desdites mesures, lesdites mesures étant effectuées avec des fréquences ou des pas de mesure différents dans ladite pluralité d'entraînements ;
et ledit modèle obtenu est sélectionné parmi lesdits modèles construits en tenant compte desdites fréquences et/ou pas de mesure et de précisions desdits modèles construits, ladite fréquence et/ou ledit pas de mesure obtenu étant la fréquence et/ou le pas de mesures utilisé pour l'entraînement dudit modèle de prédiction sélectionné.

Dans au moins certains modes de réalisation du procédé de construction et/ou du procédé de surveillance, le modèle sélectionné est le modèle de prédiction ayant la fréquence de mesure la plus faible et/ou le pas de mesure le plus grand et une précision supérieure (en valeur absolue) à une première valeur (c'est-à-dire une précision meilleure que cette première valeur).

Dans au moins certains modes de réalisation du procédé de construction et/ou du procédé de surveillance, la sélection d'un modèle parmi lesdits modèles construits tient compte d'une capacité en énergie dudit équipement.

Dans au moins certains modes de réalisation, le procédé de construction et/ou le procédé de surveillance comprend un élagage d'au moins un poids d'au moins un réseau de neurones d'au moins un modèle de prédiction construit et/ou dudit modèle de prédiction sélectionné.

Dans au moins certains modes de réalisation, le procédé de construction et/ou le procédé de surveillance comprend un gel d'au moins une couche d'au moins un réseau de neurones d'au moins un modèle de prédiction construit et/ou dudit modèle de prédiction sélectionné.

Dans au moins certains modes de réalisation, ledit équipement électromécanique peut être adapté à être alimenté en énergie par un module de captation d'une énergie ambiante.

Par capacité d'énergie, on entend ici la valeur maximale d'énergie maximale qui peut être mesurée pour l'équipement électromécanique.

La présente demande concerne aussi un procédé de construction d'un modèle de prédiction de l'énergie courante d'un équipement électromécanique comprenant
- une pluralité de prédictions de l'évolution de l'énergie dudit équipement électromécanique entre au moins deux instants, l'énergie prédite dudit équipement électromécanique à un premier desdits instants étant fonction de l'énergie effective dudit équipement électromécanique mesurée à un second desdits instants, précédant ledit premier instant, et de données représentatives d'un contexte (environnement physique et /ou activité par exemple) dudit équipement sur une plage temporelle comprise entre ledit second instant et ledit premier instant ;
- ledit premier instant étant déterminé en tenant au moins compte de l'écart entre l'énergie prédite audit second instant et l'énergie effective audit second instant.

Dans au moins certains modes de réalisation, ledit équipement électromécanique peut être adapté à être alimenté en énergie par un module de captation d'une énergie ambiante.

Dans au moins certains modes de réalisation, au moins une desdites prédictions utilise pour prédire l'énergie effective dudit équipement électromécanique audit premier instant, un modèle de réseau de neurones ayant en données d'entrée l'énergie effective dudit dispositif audit second instant et lesdites données contextuelles entre lesdits premier et second instants.

Dans au moins certains modes de réalisation, ledit premier instant est déterminé en tenant en outre compte d'un ratio entre cet écart et la capacité en énergie dudit dispositif électronique.

Dans au moins certains modes de réalisation, le procédé comprend une réception d'un espacement temporel (ou pas de mesure) et/ou d'une fréquence de mesure à respecter entre deux mesures lors d'au moins une desdites prédictions.

Les caractéristiques, présentées isolément dans la présente demande en lien avec certains modes de réalisation d'au moins un des procédés de la présente demande peuvent être combinées entre elles selon d'autres modes de réalisation de ce procédé. Selon un autre aspect, la présente demande concerne également un dispositif électronique adapté à mettre en oeuvre au moins l'un des procédés de la présente demande dans l'un quelconque de ses modes de réalisations.

Par exemple, la présente demande concerne ainsi un dispositif électronique comprenant un moins un processeur configuré pour :
- une construction d'une pluralité de modèles de prédiction de l'énergie courante d'un équipement électromécanique, à partir d'un modèle de prédiction initial, ladite pluralité de modèles de prédiction étant obtenue par une pluralité d'entraînements dudit modèle de prédiction initial tenant compte d'un historique de résultats de mesure de l'énergie courante dudit équipement associés à des données représentatives d'un contexte dudit équipement entre lesdites et /ou lors desdites mesures, lesdites mesures étant effectuées avec des fréquences ou des pas de mesure différents dans ladite pluralité d'entraînements ;
- une sélection d'un des modèles construits en tenant compte desdits fréquences et/ou pas de mesure et de précisions desdits modèles construits.

La présente demande concerne aussi par exemple un dispositif électronique comprenant un moins un processeur configuré pour une surveillance de l'énergie courante d'un équipement électromécanique, ladite surveillance comprenant :
- une obtention d'un premier modèle de prédiction de ladite énergie courante dudit équipement, et/ou d'une fréquence de mesure et/ou d'un pas de mesure de ladite énergie ;
- une prédiction, via ledit modèle de prédiction, de l'énergie dudit équipement, en utilisant en entrée dudit modèle le résultat d'une première mesure de ladite énergie courante dudit équipement et des données représentatives d'un contexte dudit équipement lors de et/ou depuis la première mesure, ladite prédiction étant effectuée avant et/ou lors d'une seconde mesure ultérieure à ladite première mesure et effectuée en respectant ladite fréquence et/ou ledit pas de mesure obtenu par rapport à ladite première mesure;
- une variation de la fréquence et/ou du pas de mesure d'au moins une mesure de l'énergie dudit équipement, ultérieure à ladite seconde mesure, en fonction d'un écart entre ladite énergie prédite et ladite seconde mesure.

La présente demande concerne aussi par exemple un système comprenant :
- au moins un dispositif électronique comprenant un moins un processeur configuré pour :
   ∘ une construction d'une pluralité de modèles de prédiction de l'énergie courante d'un équipement électromécanique, à partir d'un modèle de prédiction initial, ladite pluralité de modèles de prédiction étant obtenue par une pluralité d'entraînements dudit modèle de prédiction initial tenant compte d'un historique de résultats de mesure de l'énergie courante dudit équipement associés à des données représentatives d'un contexte dudit équipement entre lesdites et /ou lors desdites mesures, lesdites mesures étant effectuées avec des fréquences ou des pas de mesure différents dans ladite pluralité d'entraînements;
   ∘ une sélection d'un des modèles construits en tenant compte desdits fréquences et/ou pas de mesure et de précisions desdits modèles construits.
- au moins un dispositif électronique comprenant un moins un processeur configuré pour une surveillance de l'énergie courante dudit équipement électromécanique, ladite surveillance comprenant :
   ∘ une obtention d'un premier modèle de prédiction de ladite énergie courante dudit équipement, et/ou de ladite fréquence de mesure et/ou dudit pas de mesure de ladite énergie ;
   ∘ une prédiction, via ledit modèle de prédiction, de l'énergie dudit équipement, en utilisant en entrée dudit modèle le résultat d'une première mesure de ladite énergie courante dudit équipement et des données représentatives d'un contexte dudit équipement lors de et/ou depuis la première mesure, ladite prédiction étant effectuée avant et/ou lors d'une seconde mesure ultérieure à ladite première mesure et effectuée en respectant ladite fréquence et/ou ledit pas de mesure obtenu par rapport à ladite première mesure;
   ∘ une variation de la fréquence et/ou du pas de mesure d'au moins une mesure de l'énergie dudit équipement, ultérieure à ladite seconde mesure, en fonction d'un écart entre ladite énergie prédite et ladite seconde mesure.

La présente demande concerne aussi un programme d'ordinateur comprenant des instructions pour la mise en oeuvre des divers modes de réalisation d'au moins un des procédés ci-dessus, lorsque le programme d'ordinateur est exécuté par un processeur et un support d'enregistrement lisible par un dispositif électronique sur lequel est enregistré le programme d'ordinateur.

Par exemple, la présente demande concerne ainsi un programme d'ordinateur comprenant des instructions pour la mise en oeuvre, lorsque le programme est exécuté par un processeur d'un dispositif électronique, d'un procédé comprenant:
- une construction d'une pluralité de modèles de prédiction à partir d'un modèle de prédiction initial, ladite pluralité de modèles de prédiction étant obtenue par une pluralité d'entraînements dudit modèle de prédiction initial tenant compte d'un historique de résultats de mesure de l'énergie courante dudit équipement associés à des données représentatives d'un contexte dudit équipement entre lesdites et /ou lors desdites mesures, lesdites mesures étant effectuées avec des fréquences ou des pas de mesure différents dans ladite pluralité d'entraînements ;
- une sélection d'un des modèles construits en tenant compte desdits fréquences et/ou pas de mesure et de précisions desdits modèles construits.

Par exemple, la présente demande concerne ainsi un programme d'ordinateur comprenant des instructions pour la mise en oeuvre, lorsque le programme est exécuté par un processeur d'un dispositif électronique, d'un procédé de surveillance de l'énergie courante d'un équipement électromécanique, ledit procédé comprenant :
- une obtention d'un premier modèle de prédiction de ladite énergie courante dudit équipement, et/ou d'une fréquence de mesure et/ou d'un pas de mesure de ladite énergie ;
- une prédiction, via ledit modèle de prédiction, de l'énergie dudit équipement, en utilisant en entrée dudit modèle le résultat d'une première mesure de ladite énergie courante dudit équipement et des données représentatives d'un contexte dudit équipement lors de et/ou depuis la première mesure, ladite prédiction étant effectuée avant et/ou lors d'une seconde mesure ultérieure à ladite première mesure et effectuée en respectant ladite fréquence et/ou ledit pas de mesure obtenu par rapport à ladite première mesure;
- une variation de la fréquence et/ou du pas de mesure d'au moins une mesure de l'énergie dudit équipement, ultérieure à ladite seconde mesure, en fonction d'un écart entre ladite énergie prédite et ladite seconde mesure.

Par exemple, la présente demande concerne ainsi un programme d'ordinateur comprenant des instructions pour la mise en oeuvre, lorsque le programme est exécuté par un processeur d'un dispositif électronique, d'un procédé de construction d'un modèle de prédiction de l'énergie courante d'un équipement électromécanique, le procédé comprenant
- une pluralité de prédictions de l'évolution de l'énergie dudit équipement électromécanique entre au moins deux instants, l'énergie prédite dudit équipement électromécanique à un premier desdits instants étant fonction de l'énergie effective dudit équipement électromécanique mesurée à un second desdits instants, précédant ledit premier instant, et de données représentatives d'un contexte (environnement physique et /ou activité par exemple) dudit équipement sur une plage temporelle comprise entre ledit second instant et ledit premier instant ;
- ledit premier instant étant déterminé en tenant au moins compte de l'écart entre l'énergie prédite audit second instant et l'énergie effective audit second instant.

Par ailleurs, la présente demande concerne aussi un support d'enregistrement lisible par un processeur d'un dispositif électronique et sur lequel est enregistré un programme d'ordinateur comprenant des instructions pour la mise en oeuvre, lorsque le programme est exécuté par le processeur, d'un procédé comprenant :
- une construction d'une pluralité de modèles de prédiction à partir d'un modèle de prédiction initial, ladite pluralité de modèles de prédiction étant obtenue par une pluralité d'entraînements dudit modèle de prédiction initial tenant compte d'un historique de résultats de mesure de l'énergie courante dudit équipement associés à des données représentatives d'un contexte dudit équipement entre lesdites et /ou lors desdites mesures, lesdites mesures étant effectuées avec des fréquences ou des pas de mesure différents dans ladite pluralité d'entraînements ;
- une sélection d'un des modèles construits en tenant compte desdits fréquences et/ou pas de mesure et de précisions desdits modèles construits.

Par ailleurs, la présente demande concerne aussi un support d'enregistrement lisible par un processeur d'un dispositif électronique et sur lequel est enregistré un programme d'ordinateur comprenant des instructions pour la mise en oeuvre, lorsque le programme est exécuté par le processeur, d'un procédé de surveillance de l'énergie courante d'un équipement électromécanique, ledit procédé comprenant :
- une obtention d'un premier modèle de prédiction de ladite énergie courante dudit équipement, et/ou d'une fréquence de mesure et/ou d'un pas de mesure de ladite énergie ;
- une prédiction, via ledit modèle de prédiction, de l'énergie dudit équipement, en utilisant en entrée dudit modèle le résultat d'une première mesure de ladite énergie courante dudit équipement et des données représentatives d'un contexte dudit équipement lors de et/ou depuis la première mesure, ladite prédiction étant effectuée avant et/ou lors d'une seconde mesure ultérieure à ladite première mesure et effectuée en respectant ladite fréquence et/ou ledit pas de mesure obtenu par rapport à ladite première mesure;
- une variation de la fréquence et/ou du pas de mesure d'au moins une mesure de l'énergie dudit équipement, ultérieure à ladite seconde mesure, en fonction d'un écart entre ladite énergie prédite et ladite seconde mesure.

Par ailleurs, la présente demande concerne aussi un support d'enregistrement lisible par un processeur d'un dispositif électronique et sur lequel est enregistré un programme d'ordinateur comprenant des instructions pour la mise en oeuvre, lorsque le programme est exécuté par le processeur, d'un procédé de construction d'un modèle de prédiction de l'énergie courante d'un équipement électromécanique, le procédé comprenant
- une pluralité de prédictions de l'évolution de l'énergie dudit équipement électromécanique entre au moins deux instants, l'énergie prédite dudit équipement électromécanique à un premier desdits instants étant fonction de l'énergie effective dudit équipement électromécanique mesurée à un second desdits instants, précédant ledit premier instant, et de données représentatives d'un contexte (environnement physique et /ou activité par exemple) dudit équipement sur une plage temporelle comprise entre ledit second instant et ledit premier instant ;
- ledit premier instant étant déterminé en tenant au moins compte de l'écart entre l'énergie prédite audit second instant et l'énergie effective audit second instant.

Les programmes mentionnés ci-dessus peuvent utiliser n'importe quel langage de programmation, et être sous la forme de code source, code objet, ou de code intermédiaire entre code source et code objet, tel que dans une forme partiellement compilée, ou dans n'importe quelle autre forme souhaitable.

Les supports d'informations mentionnés ci-dessus peuvent être n'importe quelle entité ou dispositif capable de stocker le programme. Par exemple, un support peut comporter un moyen de stockage, tel qu'une ROM, par exemple un CD ROM ou une ROM de circuit microélectronique, ou encore un moyen d'enregistrement magnétique.

Un tel moyen de stockage peut par exemple être un disque dur, une mémoire flash, etc.

D'autre part, un support d'informations peut être un support transmissible tel qu'un signal électrique ou optique, qui peut être acheminé via un câble électrique ou optique, par radio ou par d'autres moyens. Un programme selon l'invention peut être en particulier téléchargé sur un réseau de type Internet.

Alternativement, un support d'informations peut être un circuit intégré dans lequel un programme est incorporé, le circuit étant adapté pour exécuter ou pour être utilisé dans l'exécution de l'un quelconque des modes de réalisation de l'un au moins des procédés objets de la présente demande de brevet.

De façon générale, par obtention d'un élément, on entend dans la présente demande par exemple une réception de cet élément depuis un réseau de communication, une acquisition de cet élément (via par exemple des éléments d'interface utilisateur ou des capteurs ou autres composants de mesure), une création de cet élément par divers moyens de traitement tels que par copie, encodage, décodage, transformation etc. et/ou un accès de cet élément depuis un support de stockage local ou distant accessible à au moins un dispositif mettant en oeuvre, au moins partiellement, cette obtention.

### 4. Brève description des dessins

D'autres caractéristiques et avantages de l'invention apparaîtront plus clairement à la lecture de la description suivante de modes de réalisation particuliers, donnés à titre de simples exemples illustratifs et non limitatifs, et des dessins annexés, parmi lesquels :
La [Fig 1] présente une vue simplifiée d'un système, cité à titre d'exemple, dans lequel au moins certains modes de réalisation de l'un au moins des procédés de la présente demande peuvent être implémentés,
La [Fig 2] présente une vue simplifiée d'un dispositif adapté à mettre en oeuvre au moins certains modes de réalisation d'au moins un des procédés de la présente demande,
La [Fig 3] présente un aperçu du procédé de construction de la présente demande, dans au moins certains de ses modes de réalisation
La [Fig 4] illustre un exemple de modèle de prévision selon certains modes de réalisation de l'un au moins des procédés de la présente demande
La [Fig 5] présente un aperçu du procédé de surveillance de la présente demande, dans au moins certains de ses modes de réalisation
La [Fig 6] illustre un autre exemple de modèle de prévision selon certains modes de réalisation de l'un au moins des procédés de la présente demande
La [Fig 7] illustre les énergies prédites et mesurées selon au moins certains modes de réalisation du procédé de la présente demande.

### 5. Description des modes de réalisation

La présente demande vise à aider à connaître le niveau d'énergie courant d'un équipement (ou objet) électromécanique dont le niveau d'énergie peut fluctuer en fonction de son contexte d'utilisation, tout en limitant le nombre et/ou la fréquence de mesure de son niveau d'énergie effectif (par exemple la charge effective d'une ou plusieurs batteries qui l'alimente(nt)), grâce à une prédiction de ce niveau d'énergie. La présente demande peut notamment mettre en oeuvre, au moins dans certains modes de réalisation, une technique d'intelligence Artificielle basée sur un modèle de prédiction intégrant une fonctionnalité d'adaptation dynamique au contexte d'utilisation de l'équipement. Cette adaptation dynamique peut par exemple exploiter des données contextuelles relatives à l'équipement, par exemple des données contextuelles obtenues via des flux de données, comme des flux en continu (« streaming » selon la terminologie anglaise).

A l'inverse de certaines solutions de l'art antérieur, qui prédisent, lors d'une phase opérationnelle, l'énergie courante d'un équipement à partir de mesures uniquement effectuées lors d'une phase de calibration préalable (en usine, ou lors d'une phase préalable d'initialisation, ou d'apprentissage), la présente demande propose de tenir compte de mesures effectuées lors de l'opération (ou utilisation) de l'équipement, de façon à mesurer la pertinence des prédictions, et fait varier le nombre et /ou la fréquence des mesures effectives en fonction de cette pertinence de prédiction. En effet, limiter le nombre et/ou la fréquence de mesures de l'énergie courante d'au moins une batterie d'un équipement peut aider à limiter l'énergie consommée par ses mesures.

La présente demande peut ainsi aider à obtenir des prévisions plus fiables que certaines solutions de l'art antérieur, qui supposent le profil de production et/ou de consommation énergétique d'un équipement fixe au cours du temps : En effet, différents facteurs peuvent en pratique faire varier la consommation énergétique d'un équipement. Par exemple, une production d'énergie renouvelable est par nature variable. Ainsi, un ensoleillement (ou un flux d'air ou d'eau, une différence de température, des vibrations...) peut être plus ou moins fort selon l'heure de la journée ou la météo. De ce fait, l'énergie captée pour alimenter par cet intermédiaire un équipement peut varier plus ou moins fortement tout au long de la journée.

De plus, les tâches effectuées par un équipement (et les consommations d'énergie qu'elles occasionnent) peuvent varier au fil du temps.

Enfin, le comportement en termes de consommation en énergie peut varier entre deux équipements d'un même modèle d'un constructeur, ou pour un même équipement, au fil de son vieillissement ou plus exactement au fil de l'usure de ses composants électroniques.

Limiter la mesure de l'énergie effective de l'équipement peut également aider à augmenter la durée de vie du ou des composants de mesures embarqué(s) dans l'équipement, ceux-ci étant de facto moins sollicités que s'ils étaient systématiquement utilisés pour connaître le niveau de charge de la batterie (ou tout au moins aider à éviter leur vieillissement prématuré) .

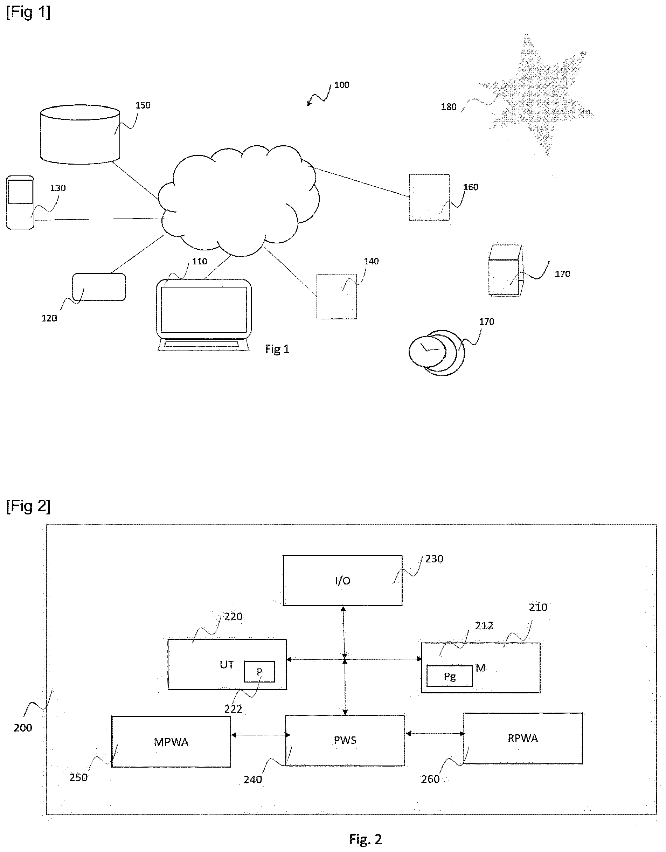

On décrit à présent, en lien avec la figure 1, de façon plus détaillée la présente demande.

La figure 1 représente un système de télécommunication 100 dans lequel certains modes de réalisation de l'invention peuvent être mis en oeuvre. Le système 100 comporte un ou plusieurs dispositifs électroniques, certains au moins pouvant communiquer entre eux via un ou plusieurs réseaux de communication, éventuellement interconnectés, comme un réseau local ou LAN (Local Area Network) et/ou un réseau de type étendu, ou WAN (Wide Area Network). Par exemple, le réseau peut comprendre un réseau LAN d'entreprise ou domestique et/ou un réseau WAN de type internet, ou cellulaire, GSM - Global System for Mobile Communications, UMTS - Universal Mobile Télécommunications System, Wifi - Wireless, etc.) .

Comme illustré en figure 1, le système 100 peut également comprendre plusieurs dispositifs électroniques, comme un terminal (tel qu'un ordinateur portable 110, un smartphone 130, une tablette 120), des objets connectés ( par exemple des objets connectés 160, 170 munis d'une batterie rechargée par le secteur et/ou alimentée par une source d'énergie ambiante 180) ou même non rechargeable, et/ou un serveur 140, par exemple un serveur d'applications, un dispositif de stockage 150. Le système peut également comprendre des éléments de gestion et/ou d'interconnexion réseau (non représentés)

La figure 2 illustre une structure simplifiée d'un dispositif électronique 200 du système 100, par exemple l'un des dispositifs 110, 120, 130, 140, 150, 160 ou 170 de la figure 1, adapté à mettre en oeuvre l'un au moins des procédés de la présente demande. Comme illustré, selon les modes de réalisation, il peut s'agir d'un serveur, d'un terminal ou d'un objet connecté.

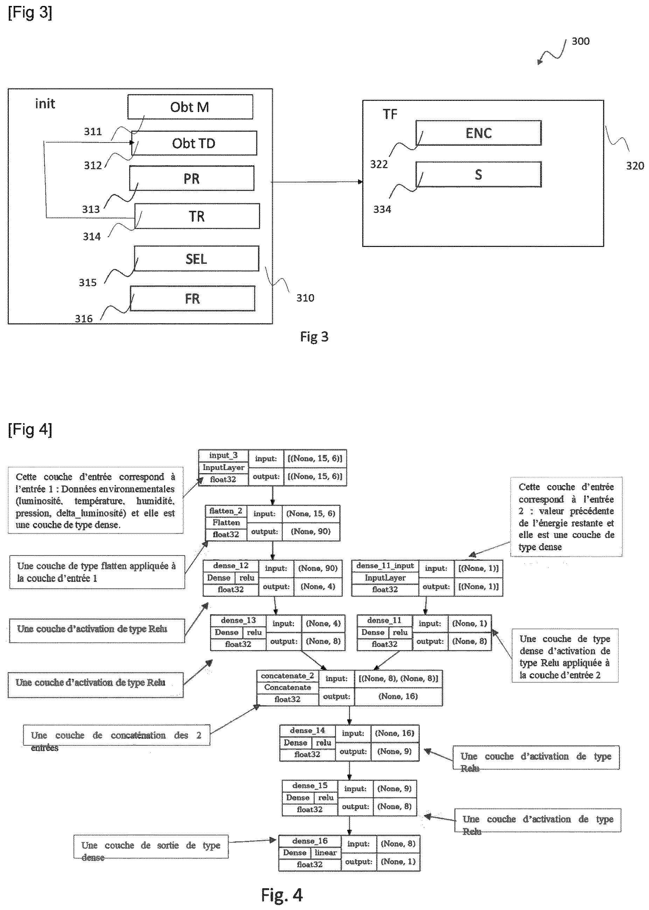

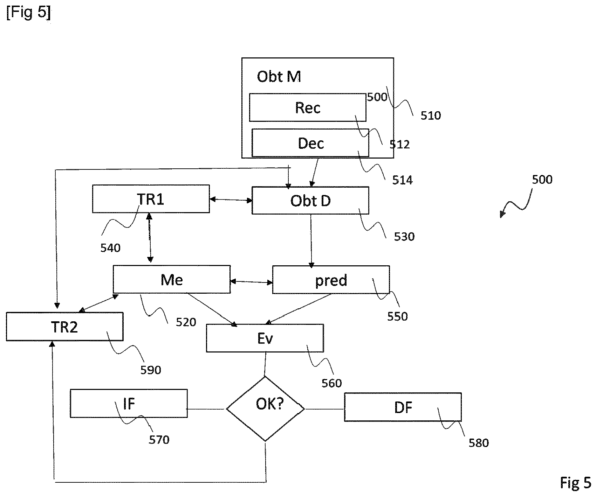

Le dispositif 200 comprend notamment au moins une mémoire M 210. Le dispositif 200 peut notamment comprendre une mémoire tampon, une mémoire volatile, par exemple de type RAM (pour « Random Access Memory » selon la terminologie anglaise), et/ou une mémoire non volatile (par exemple de type ROM (pour « Read Only Memory » selon la terminologie anglaise). Le dispositif 200 peut également comprendre une unité de traitement UT 220, équipée par exemple d'au moins un processeur P 222, et pilotée par un programme d'ordinateur PG 212 stocké en mémoire M 210. A l'initialisation, les instructions de code du programme d'ordinateur PG sont par exemple chargées dans une mémoire RAM avant d'être exécutées par le processeur P. Ledit au moins un processeur P 222 de l'unité de traitement UT 220 peut notamment mettre en oeuvre, individuellement ou collectivement, l'un quelconque de modes de réalisation de l'un et/ou l'autre des procédés de la présente demande (décrits notamment en relation avec les figures 3 et 5), selon les instructions du programme d'ordinateur PG.

Le dispositif 200 peut par exemple comprendre (ou être couplé à) un module PWS 240 de stockage en énergie (comme une batterie), un module MPWA 250 d'alimentation en énergie, couplé par exemple, via un module de connexion, au secteur (« Mains » selon la terminologie anglaise), et/ou un module RPWA 260 d'acquisition d'une énergie ambiante (via des cellules solaires par exemple ou tout autre mode d'apport d'énergie ambiante).

Le dispositif peut également comporter, ou être couplé à, au moins un module d'entrée/ sortie I/O 230, tel qu'un module de communication, permettant par exemple au dispositif 200 de communiquer avec d'autres dispositifs du système 100, via des interfaces de communication filaires ou sans fils, et/ou tel qu'un module d'interfaçage avec un utilisateur du dispositif (aussi appelé plus simplement dans cette demande « interface utilisateur ».

Par interface utilisateur du dispositif, on entend par exemple une interface intégrée au dispositif 200, ou une partie d'un dispositif tiers couplé à ce dispositif par des moyens de communication filaires ou sans fils. Par exemple, il peut s'agir d'un écran secondaire du dispositif ou d'un ensemble de hauts parleurs connectés par une technologie sans fils au dispositif

Une interface utilisateur peut notamment être une interface utilisateur, dite «de sortie», adaptée à un rendu (ou au contrôle d'un rendu) d'un élément de sortie d'une application informatique utilisée par le dispositif 200, par exemple une application s'exécutant au moins partiellement sur le dispositif 200 ou une application « en ligne » s'exécutant au moins partiellement à distance, par exemple sur le serveur 140 du système 100. Des exemples d'interface utilisateur de sortie du dispositif incluent un ou plusieurs écrans, notamment au moins un écran graphique (tactile par exemple), un ou plusieurs haut-parleurs, un casque connecté.

Par ailleurs, une interface utilisateur peut être une interface utilisateur, dite «d'entrée», adaptée à une acquisition d'une commande d'un utilisateur du dispositif 200. Il peut s'agir notamment d'une action à effectuer en lien avec un item restitué, et/ou d'une commande à transmettre à une application informatique utilisée par le dispositif 200, par exemple une application s'exécutant au moins partiellement sur le dispositif 200 ou une application « en ligne » s'exécutant au moins partiellement à distance, par exemple sur le serveur 140 du système 100. Des exemples d'interface utilisateur d'entrée du dispositif 200 incluent un moyen d'acquisition audio et/ou vidéo (microphone, caméra (webcam) par exemple), un clavier, une souris.

De tels moyens d'entrées/sorties peuvent par exemple être adaptés au paramétrage du dispositif 200.

Dans certains modes de réalisation, les modules d'entrées/ sorties peuvent également comprendre des moyens d'obtention de mesures d'énergie. Il peut s'agir selon les modes de réalisation de moyens de communication adaptés à recevoir des résultats de mesure effectuées par un autre dispositif sur un équipement dont on souhaite surveiller le niveau d'énergie, et/ou de moyens de réalisation de ces mesures sur ledit dispositif (de façon à mesurer sa propre énergie).

L'énergie de l'équipement et/ou du dispositif peut par exemple être mesurée via un ou plusieurs composants électroniques spécifiques, embarqués dans l'équipement et/ou le dispositif lui-même, mesurant chacun le niveau d'énergie directement aux bornes d'une batterie de l'équipement et/ou du dispositif. Un exemple de tel composant est le composant référencé INA231 par Texas instrument ^{©}.

Dans certains modes de réalisation, les modules d'entrées/ sorties peuvent également comprendre des moyens d'obtention de données contextuelles, représentatives par exemple du contexte ambiant (ou environnement physique) d'un équipement, ou de l'activité du dispositif lors de et/ou entre les mesures d'énergie. Il peut s'agir selon les modes de réalisation de moyens de communication adaptés à recevoir de telles données acquises sur au moins un autre dispositif (comme un capteur de luminosité, de température, d'humidité de pression etc..), situé par exemple à proximité d'un équipement dont on souhaite surveiller le niveau d'énergie, et/ou de moyens d'acquisition de telles données. Ces moyens d'acquisition peuvent comprendre des capteurs physiques ou logiciel (par exemple des sondes logiciels adaptées à mesurer un nombre et/ou une fréquence de sollicitations de l'équipement par un utilisateur, et/ou un nombre et/ou une fréquence (et éventuellement un type) de données (comme des messages) envoyées et/ou reçues par l'équipement).

Ledit au moins un microprocesseur du dispositif 200 peut notamment être adapté pour :
- une construction d'une pluralité de modèles de prédiction de l'énergie courante d'un équipement électromécanique, à partir d'un modèle de prédiction initial, ladite pluralité de modèles de prédiction étant obtenue par une pluralité d'entraînements dudit modèle de prédiction initial tenant compte d'un historique de résultats de mesure de l'énergie courante dudit équipement associés à des données représentatives d'un contexte dudit équipement entre lesdites et /ou lors desdites mesures, lesdites mesures étant effectuées avec des fréquences ou des pas de mesure différents dans ladite pluralité d'entraînements ;
- une sélection d'un des modèles construits en tenant compte desdits fréquences et/ou pas de mesure et de précisions desdits modèles construits.

Ledit au moins un microprocesseur du dispositif 200 peut notamment être adapté pour une surveillance de l'énergie courante d'un équipement électromécanique, la surveillance comprenant :
- une obtention d'un premier modèle de prédiction de ladite énergie courante dudit équipement, et/ou d'une fréquence de mesure et/ou d'un pas de mesure de ladite énergie ;
- une prédiction, via ledit modèle de prédiction, de l'énergie dudit équipement, en utilisant en entrée dudit modèle le résultat d'une première mesure de ladite énergie courante dudit équipement et des données représentatives d'un contexte dudit équipement lors de et/ou depuis la première mesure, ladite prédiction étant effectuée avant et/ou lors d'une seconde mesure ultérieure à ladite première mesure et effectuée en respectant ladite fréquence et/ou ledit pas de mesure obtenu par rapport à ladite première mesure;
- une variation de la fréquence et/ou du pas de mesure d'au moins une mesure de l'énergie dudit équipement, ultérieure à ladite seconde mesure, en fonction d'un écart entre ladite énergie prédite et ladite seconde mesure.

Ledit au moins un microprocesseur du dispositif 200 peut notamment être adapté pour :
- une pluralité de prédictions de l'évolution de l'énergie dudit équipement électromécanique entre au moins deux instants, l'énergie prédite dudit équipement électromécanique à un premier desdits instants étant fonction de l'énergie effective dudit équipement électromécanique mesurée à un second desdits instants, précédant ledit premier instant, et de données représentatives d'un contexte (environnement physique et /ou activité par exemple) dudit équipement sur une plage temporelle comprise entre ledit second instant et ledit premier instant ;
- ledit premier instant étant déterminé en tenant au moins compte de l'écart entre l'énergie prédite audit second instant et l'énergie effective audit second instant.

Dans certains modes de réalisation, les procédés ci-dessus peuvent être mis en oeuvre de façon distribuée entre au moins deux dispositifs 110, 120, 130, 140, 150, 160 et/ou 170 du système 100. Ainsi, la présente demande est parfois détaillée en lien avec un premier dispositif (par exemple un serveur 140 du système 100) construisant un modèle (selon le procédé de construction ci-dessus) qu'il communique à au moins un second dispositif (par exemple un terminal 110 ou un dispositif de stockage 150 du système 100, de qui le terminal 110 pourra ultérieurement obtenir ce modèle). Un second dispositif (par exemple le terminal 110) peut utiliser ce modèle (selon le procédé de surveillance ci-dessus) pour surveiller l'énergie d'un troisième dispositif (tel qu'un objet connecté 160 ou 170) .

Dans d'autres modes de réalisation, le procédé de surveillance de la présente demande peut être mis en oeuvre localement par un équipement recevant un modèle d'un autre dispositif (par exemple un serveur 140 ou le dispositif de stockage 150) et l'utilisant pour surveiller sa propre énergie. Dans encore d'autres modes de réalisation, le procédé de surveillance de la présente demande peut être mis en oeuvre localement par un équipement construisant son propre modèle et surveillant sa propre énergie. Certains des modules d'entrée -sorties ci-dessus sont optionnels et peuvent donc être absents du dispositif 200 dans certains modes de réalisation. Notamment, lorsque les procédés sont mis en oeuvre localement par un équipement construisant son propre modèle et surveillant sa propre énergie, certains modules d'entrées/sorties liés à la transmission ou réception de données peuvent être absents.

Par le terme « module » ou le terme « composant » ou «élément » du dispositif, on entend ici un élément matériel, notamment câblé, ou un élément logiciel, ou une combinaison d'au moins un élément matériel et d'au moins un élément logiciel. Les procédés selon l'invention peuvent donc être mis en oeuvre de diverses manières, selon leurs modes de réalisation, notamment sous forme câblée et/ou sous forme logicielle.

On présente à présent, en lien avec les figures 3 à 5, certaines mises en oeuvre de la présente demande, où un procédé 300 de construction, illustré en figure 3 est mis en oeuvre sur un premier dispositif électronique (qui peut être similaire au dispositif 200 de la figure 2). tel que le serveur 140 illustré en figure 1 et un procédé 500 de surveillance est mis en oeuvre sur un second dispositif électronique (qui peut être similaire au dispositif 200 de la figure 2), tel que le terminal 110 de la figure 1. Par souci de clarification, on utilisera dans la suite de la présente demande :
- le terme « premier dispositif» pour se référer au dispositif mettant en oeuvre le procédé de construction de la présente demande,
- le terme « second dispositif» pour se référer au dispositif mettant en oeuvre le procédé de surveillance de la présente demande, ie le dispositif surveillant (ou « monitoring device » selon la terminologie anglaise), et
- le terme « équipement », ou « équipement électromécanique », ou « objet connecté», pour se référer au dispositif dont l'énergie est surveillée, ie au dispositif surveillé (ou « monitored device » selon la terminologie anglaise).

Comme exposé ci-dessus, il peut selon les modes de réalisation s'agir d'un même dispositif ou de dispositifs différents.

Construire le modèle de prédiction sur un « premier » dispositif autre que le dispositif surveillant l'équipement ou que l'équipement surveillé lui-même peut aider à tirer parti, lors de cette construction, de ressources de calcul et/ou de traitement du premier dispositif supérieures à celles disponibles sur le dispositif surveillant l'équipement ou sur l'équipement lui-même.

De même, surveiller l'énergie de l'équipement via un « second » dispositif peut aider à tirer parti, lors de cette surveillance de ressources de calcul et/ou de traitement du second dispositif supérieures à celles disponibles sur l'équipement lui-même .

De plus, la mise en oeuvre de la construction du modèle de prédiction et/ou de la surveillance de l'énergie sur des dispositifs autres que l'équipement lui-même peut permettre une construction de modèles et/ou une surveillance pour plusieurs équipements au sein d'un même dispositif et donc une mise en commun de certains traitements.

Par ailleurs, une implémentation locale à l'équipement ou au second dispositif peut aider à simplifier la mise en oeuvre de la solution objet de la présente demande, et donc aider à limiter son coût d'implémentation. En particulier, certaines étapes des procédés décrits ci-après (par exemple la transmission du modèle sélectionné et/ou de la fréquence associée) peuvent optionnelles dans de tels modes de réalisation.

La figure 3 illustre le procédé 300 de construction d'un modèle de prédiction de la présente demande, dans une mise en oeuvre sur un premier dispositif (comme un serveur).

Comme illustré, le procédé 300 peut comprendre une phase d'obtention 310 d'un modèle 310, au cours de laquelle est initialisé un modèle de prédiction qui pourra ensuite être utilisé pour prédire l'énergie de l'équipement par le second dispositif (ou par l'équipement lui-même).

Plus précisément, lors de l'obtention 310, un modèle de prévision d'une énergie (ou charge) courante de l'équipement est entraîné via un apprentissage automatique.

L'obtention comprend ainsi, dans le mode de réalisation illustré, une définition 311 d'un modèle initial, qui est ensuite entraîné. La charge de l'équipement à un instant courant (t1) est liée à sa charge à un instant (t0), précédant cet instant courant, et à l'évolution de l'environnement de l'équipement entre les instants t0 et t1. De ce fait, comme dans l'exemple illustré en figure 3, le modèle de prédiction peut prendre en paramètres d'entrée une valeur d'énergie mesurée antérieurement à l'instant courant (ie l'énergie effective mesurée à un instant t0 précédant l'instant t1 courant) (par exemple le résultat d'au moins une des n dernières mesures d'énergie effectuées (avec n entier), comme la dernière ou les n dernières mesures effectuées) et au moins une donnée contextuelle se rapportant au contexte de l'équipement pendant l'intervalle de temps écoulé depuis cette ou ces mesures (ie l'intervalle temporel entre t0 et t1). L'au moins une donnée contextuelle peut par exemple comprendre au moins une donnée relative à l'environnement ambiant de l'équipement comme une valeur courante et/ou une variation d'une luminosité ambiante, d'une température ambiante, d'une pression et/ou d'une humidité ambiante dans cet intervalle de temps. L'au moins une donnée contextuelle peut par exemple comprendre au moins une donnée relative à une énergie extérieure reçue par l'équipement (via le secteur par exemple). L'au moins une donnée contextuelle peut par ailleurs comprendre par exemple au moins une donnée relative à l'activité de l'équipement comme une nature d'au moins une tâche effectuée représentant une consommation d'énergie, un nombre de répétition de la tâche, une durée de la tâche, un nombre et/ou une fréquence de sollicitations par un utilisateur, un nombre et/ou une fréquence d'envoi et/ou de réception de données (par exemple des messages) par l'équipement, un type et/ou une taille de données envoyées, reçues, ou plus généralement traitées par l'équipement, etc..

Dans l'exemple illustré où l'équipement à surveiller est alimenté au moins partiellement par une source d'énergie ambiante, le modèle initial peut par exemple être un modèle de régression non linéaire multi-entrées. En effet, en apprentissage automatique, la régression couvre les méthodes d'analyse statistique permettant de prédire une variable quantitative à partir d'autres variables qui lui sont corrélées. Comme la variation en énergie (ie sa charge et/ou sa décharge en énergie) de l'équipement à surveiller est inconnue, et que la variation d'énergie peut être impactée par des facteurs externes variables dans le temps (comme exposé ci-dessus), pouvant lui donner un caractère non linéaire, le modèle initial peut être choisi comme un modèle de régression non linéaire.

Dans certains modes de réalisation où la définition (ou obtention) 311 du modèle utilise une technologie de réseaux de neurones, la définition 311 peut comprendre un choix et/ou un ajustement des hyperparamètres (nombre, type et taille des couches, taille globale, etc.) du modèle en cours de définition via un outil logiciel d'ajustement d'hyperparamètres de modèles d'intelligence artificielle, comme l'outil Keras Tuner ^{©} par exemple. Ainsi, la figure 4 illustre un exemple de modèle de prévision obtenu via l'outil d'ajustement d'hyperparamètres Keras Tuner ^{©}. En particulier, comme dans cet exemple, des bornes minimales et maximales des hyperparamètres peuvent être fournies à l'outil utilisé, de façon à aider à l'obtention d'un modèle adapté (en taille et/ou en temps de traitement) à un dispositif sur lequel est prévu une inférence du modèle (comme le « second » dispositif et/ou l'équipement à surveiller (comme les objets connectés 160, 170)).

Par ailleurs, comme illustré dans l'exemple de la figure 3, le procédé peut comprendre une phase d'obtention 312 de données d'entraînement (ou d'apprentissage). Dans certains modes de réalisation, il peut s'agir de données relatives à l'équipement à surveiller. Par exemple, il peut s'agir d'une réception ou d'une acquisition d'une pluralité de valeurs d'énergie mesurées sur cet équipement, à plusieurs instants, et des données contextuelles (environnementales et/ou d'activité) se rapportant aux intervalles temporels entre ces instants.

En variante, dans certains modes de réalisation, les données d'apprentissage peuvent être des données relatives à un autre équipement que l'équipement à surveiller, du même modèle que l'équipement à surveiller, ou des données obtenues, lors d'une phase de test par exemple, en fin de fabrication de l'équipement à surveiller.

Dans le mode de réalisation illustré, le procédé 300 de construction peut comprendre une phase apprentissage 314 (aussi appelé entraînement) mise en oeuvre à partir du modèle initial précédemment construit 311 pour ajuster les paramètres (poids, bias etc., ..) des couches de ce modèle sur la base des données d'entraînement obtenues 312.

La phase d'apprentissage 314 peut par exemple être réitérée jusqu'à l'atteinte d'au moins un critère d'arrêt. Par exemple, un critère d'arrêt peut être l'atteinte ou le dépassement d'une précision requise du modèle.

On appelle dans la présente demande « précision » du modèle la valeur absolue de l'écart entre l'énergie prédite par le modèle et l'énergie effective (mesurée).

On appelle précision requise du modèle (notée « Diff-req » ci-après) une valeur maximale de la précision.

Ainsi, le critère d'arrêt ci-dessus peut se traduire par une précision (donc la valeur absolue de l'écart) inférieure (en valeur absolue) à une certaine valeur correspondant à la précision requise du modèle.

Cette précision requise peut par exemple être paramétrable et différer selon la nature de l'équipement surveillé.

D'autres critères peuvent être pris en compte dans d'autres modes de réalisation. Par exemple, un critère d'arrêt peut être une variation « trop faible » de cet écart, même s'il reste supérieur à la précision requise (par exemple une variation de l'écart restant inférieure à une certaine valeur constante paramétrable pendant un nombre paramétrable d'itérations successives). Dit simplement, un critère d'arrêt serait la « stagnation » de la précision obtenue en sortie d'apprentissage à une valeur restant supérieure à la précision requise (donc une valeur « plus mauvaise » que la précision requise).

Comme illustré en figure 3, dans certains modes de réalisation, la phase d'entraînement 314 peut être effectuée plusieurs fois, avec différents espacements temporels de mesures. Par exemple, chaque apprentissage peut utiliser des données d'historique correspondant à un espacement temporel (ou « pas ») constant entre les mesures, cet espacement étant différent d'un apprentissage à l'autre (par exemple chacun des espacements des apprentissages est différent des autres). Par exemple, on peut utiliser pour différents entraînements successifs un pas de mesure de plus en plus grand (ie une fréquence de plus en plus faible), augmenté par exemple à chaque itération via un coefficient multiplicatif, ou par addition au pas de mesure (ou par soustraction à la fréquence) d'une certaine constante. La variation de la fréquence et/ou du pas de mesure peut notamment être fonction de l'équipement à surveiller. Par exemple, des valeurs minimales et maximales peuvent être choisies en fonction de l'équipement à surveiller, et de ses ressources maximales en énergie, de sa consommation moyenne sur une période de référence etc.. On obtient ainsi une pluralité de modèles entraînés avec différents pas de mesure (ou différentes fréquences) à partir du modèle initial. De tels modes de réalisation peuvent comprendre une sélection 315 d'au moins un des modèles entraînés, en fonction des pas de mesure utilisés lors des différents apprentissages et de la précision d'au moins un de ces modèles. De tels modes de réalisation peuvent aider à limiter le nombre et/ou la fréquence des mesures tout en aidant à respecter la précision requise. Il s'agit par exemple de sélectionner la fréquence de mesure la plus faible permettant d'atteindre une précision requise Difff-req. La fréquence sélectionnée lors de cette phase d'obtention 310 sera notée (F1), dans la suite de la demande.

Dans le mode de réalisation illustré en figure 3, le procédé 300 de construction peut comprendre au moins une optimisation (optionnelle) du modèle. Cette optimisation peut être effectuée selon les modes de réalisation avant ou après l'apprentissage et, dans ce cas sur l'ensemble des modèles entraînés ou uniquement sur celui ou ceux sélectionné(s). Une optimisation du modèle avant entraînement peut aider à limiter les ressources (en temps et en capacité de calcul) nécessaires aux différents entraînements. Par exemple, dans certains modes de réalisation, une première optimisation 313 peut par exemple mettre en oeuvre des techniques d'élagage (ou « pruning » selon la terminologie anglaise), c'est-à-dire des techniques d'optimisation mettant (par exemple progressivement) à zéro les poids les moins significatifs du modèle de façon à réduire les matrices de poids du modèle (et donc son encombrement mémoire et les ressources nécessaires à son exploitation lors de l'apprentissage comme lors d'une inférence ultérieur). Un tel mode de réalisation aide donc à la parcimonie du modèle. Selon les modes de réalisation, par exemple selon les capacités mémoire et de traitement du dispositif 200, différentes techniques d'élagage peuvent être utilisées. Par exemple, dans certains modes de réalisation, l'élagage peut utiliser une technique identique ou similaire à celle décrite par T. Yang, Y. Chen and V. Sze ("Designing Energy-Efficient Convolutional Neural Networks Using Energy-Aware Pruning," 2017 IEEE Conférence on Computer Vision and Pattern Recognition (CVPR), 2017, pp. 6071-6079, doi: 10.1109/CVPR.2017.643).

L'optimisation 313 par élagage du modèle peut aider à limiter la taille et la complexité du modèle de façon à le rendre adapté aux capacités de mémoire et de traitement d'un second dispositif et/ou d'un équipement sur lequel il va être utilisé (voir par exemple le procédé de surveillance détaillé plus loin), et notamment d'un second dispositif et/ou d'un équipement de capacités de mémoire et de traitement plus faibles que celles du premier dispositif.

Dans l'exemple de la figure 3, le procédé peut comporter, une seconde optimisation 316 (optionnelle également) des modèles (par exemple de l'ensemble des modèles une fois entraînés ou uniquement du ou des modèles sélectionnés).

Cette seconde optimisation 316 peut par exemple comprendre un « gel » (« freeze » selon la terminologie anglaise) d'au moins une couche du modèle (par exemple une des couches hautes ) tout en laissant au moins une autre couche (par exemple une des dernières couches) non gelées. Geler (ou fixer) des couches signifie ici une désactivation du calcul du gradient et de la rétropropagation des poids de ces couches (qui sont donc « figées » ie n'évoluent plus ). Les premières couches d'un réseau de neurones (par exemple celle(s) recevant les données d'entrée du modèle) codent des caractéristiques générales des données d'entrée. Ainsi, les premières couches du modèle construit trouvent, par exemple, des liens généraux entre la courbe de charge et /ou de décharge de l'équipement et les données environnementales. Les couches finales sont plus spécifiques à une activité (ou tâche), spécifique de l'équipement, ou à des conditions environnementales particulières).

Par exemple, les caractéristiques générales peuvent être traduites par une corrélation positive entre l'énergie et l'environnement (le fait que l'énergie diminue quand la luminosité diminue) et les détails peuvent se traduire par des valeurs exactes des données (par exemple, le modèle peut apprendre via ses couches basses que quand la luminosité augmente de **x** lux, l'énergie va augmenter de **y** V)

Le gel d'au moins une couche haute peut aider à réduire les risques de surajustement (ou surapprentissage) du modèle de prédiction. Un surapprentissage peut se produire quand le modèle devient très (voir trop) lié aux données d'apprentissage. Le fait de geler les couches hautes, par exemple, peut aider le modèle de garder ses connaissances générales (acquises lors de la phase d'apprentissage).

Le gel d'au moins une couche haute peut aussi aider à limiter les ressources mémoire et de traitement nécessaires à un optionnel réentraînement du modèle (puisque seules les couches non figées feront l'objet de ce réentraînement).

Dans certains modes de réalisation, où la surveillance de l'équipement est effectuée par un autre dispositif (le second dispositif ou l'équipement lui-même), le procédé peut comprendre un transfert 320 vers cet autre dispositif du modèle sélectionné et/ou de la fréquence et/ou du pas de mesure utilisé pour son entraînement. Optionnellement d'autres paramètres peuvent être transférés, tels que des indicateurs représentant le type des données contextuelles utilisées lors de l'entraînement du modèle. Ce transfert peut par exemple comporter un envoi 324 des paramètres (hyperparamètres, poids, bias) caractérisant le modèle.

Le transfert 520 peut comporter dans certains modes de réalisation un encodage 322 (comme une compression) d'au moins certains des éléments à envoyer, comme les paramètres du modèle.

On présente à présent, en lien avec la figure 5, certains modes de réalisation du procédé 500 de surveillance de la présente demande. Le procédé 500 peut par exemple être implémenté par un « second » dispositif électronique surveillant un équipement électromécanique ou dans cet équipement lui-même.

Comme détaillé ci-après en lien avec la figure 5, le procédé 5 de surveillance 500 peut comprendre une obtention 510 d'un modèle de prédiction et/ou de données associées à ce modèle. Plus précisément, il peut s'agir dans certains modes de réalisation, d'une réception 512 d'un modèle et de données associées comprenant par exemple une fréquence (F1) et/ou un pas de mesure et/ou des indications relatives aux types de données contextuelles considérées pendant la construction du modèle. Ce modèle peut exemple être un modèle déjà entraîné et éventuellement optimisé (construit par exemple en utilisant le procédé 300 détaillé ci-dessus en lien avec les figures 3 et 4). Dans certains modes de réalisation, le procédé peut comprendre, comme illustré, un éventuel décodage 514 d'éléments reçus (résultant d'une compression antérieure) pour l'obtention de ce modèle et de ses données associées.

En variante, l'obtention 510 du modèle de prédiction et des données associées peut comprendre une construction (non illustrée) du modèle de prédiction, de façon similaire à ce qui a été décrit ci-avant en liaison avec l'obtention du modèle de prédiction (et ses données associées) selon le procédé 300 de construction.

Dans certains modes de réalisation, le procédé 500 comprend d'une part une obtention 520 une pluralité de résultats de mesures de l'énergie de l'équipement à surveiller. Ces mesures peuvent être effectuées avec une fréquence (F1) correspondant à la fréquence et/ou au pas de mesure obtenu(s) en association avec le modèle de prédiction.

Le procédé 500 peut également comprendre, en parallèle aux mesures, une obtention 530 de données relatives au contexte (environnement, activité etc..) de l'équipement lors de et/ou entre ces mesures.

Dans certains modes de réalisation, par exemple lorsque le modèle a été appris sur un autre dispositif (comme illustré en figure 3 par exemple), le procédé 500 peut comprendre un apprentissage 540 du modèle de prédiction obtenu 510 sur des données propres à l'équipement à surveiller et correspondant à son contexte (en termes d'environnement et/ou d'activité) immédiat. Cet apprentissage 540 peut par exemple se baser sur un historique de mesures de l'énergie de l'équipement (par exemple un historique d'une dizaine de mesures), ainsi sur des données contextuelles (environnementales et/ou relatives à son activité par exemple) lors de et/ou entre ces mesures. Un tel apprentissage peut être effectué dans certains modes de réalisation avant toute inférence du modèle.

Le modèle obtenu 510 peut en effet avoir été précédemment entraîné sur un autre type d'équipement ou avec les données contextuelles (conditions environnementales, activité de l'équipement) très différentes des conditions courantes de l'équipement. Ce nouvel apprentissage peut par exemple aider à un alignement ultérieur plus rapide du modèle de prédiction, lors de son inférence, avec le comportement réel en termes d'énergie de cet équipement, dans son contexte courant, du fait de la similarité entre les données d'entraînement (équipement concerné, contexte d'environnement et d'activité, etc...) et les données utilisées en entrée du modèle lors de son inférence pour prédire l'énergie de cet équipement.

Selon la figure 5, le procédé 500 comprend une inférence (ou déploiement) du modèle de prédiction, de façon à pouvoir estimer l'énergie courante de l'équipement entre deux mesures de son énergie effective.

De telles estimations peuvent par exemple être utilisées pour prédire des risques de décharge de l'équipement à surveiller et/ou adopter en conséquence des actions préventives, comme des modifications d'au moins une activité de l'équipement à surveiller (comme la limitation ou l'interdiction de certaines actions consommatrices d'énergie), ou l'ajout ou activation d'une source d'énergie ambiante (allumage d'une lampe à proximité de l'équipement à surveiller), ou une connexion de l'équipement à une source d'énergie comme le secteur ou une batterie secondaire.

Par exemple, dans certains modes de réalisation, une prédiction 550 peut être effectuée de façon périodique ou suite à l'obtention d'au moins une donnée contextuelle, de façon par exemple à tenir compte de l'impact des changements de données contextuelles (changement des caractéristiques de l'environnement et/ou changement de l'activité de l'équipement) sur le niveau d'énergie de l'équipement.

Il peut s'agir par exemple de données contextuelles (par exemple environnementales) collectées de façon périodique, avec une plus forte fréquence que la fréquence des mesures d'énergie (par exemple une fréquence plusieurs fois (par exemple 3 à 6 fois) supérieure à la fréquence des mesures d'énergie) ou ayant une période inférieure au pas des mesures d'énergie. Il peut aussi s'agir de données contextuelles obtenues de façon non périodique (voire même aléatoire), comme des données contextuelles liées à la survenue d'un évènement (par exemple une activité de l'équipement)) auxquelles elles se rapportent.

Ces données contextuelles peuvent par exemple être extraites de flux de données reçus par le second dispositif en provenance de l'équipement, ou de dispositifs tiers (capteurs par exemple) situés à proximité de l'équipement.

La prédiction 560 peut notamment être effectuée lors de l'obtention du résultat (courant) d'une mesure de l'énergie de l'équipement, de façon à pouvoir vérifier la précision du modèle de prédiction.

Ainsi, dans certains modes de réalisation, le procédé peut comprendre une comparaison de la valeur mesurée de l'énergie à un instant courant t, avec une valeur prédite de l'énergie de l'équipement, au même instant courant t, issue du modèle de prédiction obtenu (et éventuellement entraîné localement). Le résultat de cette comparaison correspond à la précision courante du modèle de prédiction. Dans certains modes de réalisation, le procédé 500 peut comprendre une variation 570, 580 de la fréquence de mesures (ou du pas de mesure) en fonction au moins de la précision courante du modèle. Cette variation peut par exemple être mise en oeuvre lorsque la précision du modèle reste supérieure à la précision requise Diff-Req pendant plusieurs mesures successives, et correspondre à une réduction 580 de la fréquence de mesures (ou une augmentation du pas de mesure). En effet, il est inutile de mesurer fréquemment l'énergie si le modèle peut la prédire avec la précision requise. De plus espacer les mesures permet de limiter l'énergie consommée par ces mesures. A l'inverse, cette variation peut par exemple être mise en oeuvre lorsque la précision du modèle reste inférieure à la précision requise Diff-Req pendant plusieurs mesures successives, et correspondre à une augmentation 570 de la fréquence de mesures (ou une diminution du pas de mesure).

La variation de la fréquence et/ou du pas de mesure peut différer selon les modes de réalisation. Par exemple, un facteur multiplicatif strictement supérieur à 1 peut être appliqué à la fréquence courante pour augmenter la fréquence de mesures, et un facteur multiplicatif strictement inférieur à 1 peut être appliqué à la fréquence courante pour réduire la fréquence de mesures (ou vice et versa pour un pas de mesure) . Dans certains modes de réalisation, le procédé peut comprendre, lors de l'inférence du modèle, un réentraînement 590 du modèle de prédiction lorsque sa précision devient trop faible, ie quand la valeur absolue de l'écart entre énergies mesurée et prédite devient supérieure à une valeur (notée ici MaxDiff) (et utilisée par exemple comme seuil) pendant une ou plusieurs mesures consécutives. Cette valeur MaxDiff peut dépendre de la nature de l'équipement et/ou de la précision requise Diff-Req introduite précédemment.

Un écart important peut correspondre à un changement brusque de l'environnement (une lampe qui s'allume par exemple pour un équipement situé à intérieur d'un bâtiment, ou un nuage qui abaisse brutalement la luminosité pour un équipement situé en extérieur). L'écart peut aussi correspondre à un apport brusque d'énergie externe à l'équipement (l'équipement est branché sur une source d'alimentation externe), ou encore à un changement brutal de l'activité de l'équipement (par exemple un début ou fin d'activité de l'équipement).

Un réentrainement du modèle de prédiction, même avec un faible nombre de données d'apprentissage, peut aider le modèle de prédiction à s'adapter plus rapidement à de tels changements brusques. Le réentrainement peut par exemple être effectué avec une plus faible quantité de données que lors de l'entraînement local avant le début de l'inférence du modèle.

Dans au moins certains modes de réalisation, les procédés de la présente demande peuvent ainsi aider à étendre la durée de vie d'un équipement (ou tout au moins aider à limiter un vieillissement de l'équipement occasionné par des mesures de son énergie) en limitant le nombre de mesures d'énergie effectuées sur l'équipement. Tenir compte, dans la prédiction, de données contextuelles (relatives à l'environnement physique de l'équipement et/ou à son activité) comme de la charge telle que précédemment mesurée de l'équipement peut de plus aider à obtenir une meilleure précision du modèle de prédiction, ce qui peut permettre la mise en oeuvre d'actions plus appropriées ou plus précoces, qu'avec des procédés de mesure d'énergie classiques. De telles actions peuvent par exemple aider à éviter les pannes d'énergie de l'équipement, et/ou aider à ce que l'équipement reste actif plus longtemps, et/ou à aider à mieux gérer les capacités de production et/ou de consommation de l'équipement.

La présente demande a été présentée par souci de simplification avec une précision requise du modèle de prédiction identique lors des phases d'entraînements et d'inférence. Dans certains modes de réalisation, des précision différentes peuvent être requises pour le modèle de prédiction lors des phases d'entraînements et d'inférence. En particulier, lors de l'inférence, la précision requise du modèle de prédiction à un instant courant peut varier dans certains modes de réalisation en fonction de la valeur prédite et/ou mesurée de l'équipement à un instant précédant l'instant courant. Un tel mode de réalisation peut par exemple permettre de limiter davantage la fréquence des mesures lorsque l'énergie effective de l'équipement diminue, voire même de les supprimer, lorsque l'énergie courante de l'équipement devient très faible (de façon à éviter par exemple que les dernières ressources en énergie de l 'équipement soit gaspillées à mesurer cette énergie).

La présente demande peut s'appliquer à tout type d'équipement de type « loT » (pour Internet of Things » selon la terminologie anglaise) ou industriel, fixe ou mobile, nécessitant par exemple une gestion fine de sa consommation et/ou production d'énergie pour son fonctionnement, ou ayant besoin d'une prédiction fine à court terme (comme dans les minutes à venir) de sa propre consommation et/ou de sa production. On présente à présent des résultats de la mise en oeuvre de certains modes de réalisation de la présente demande, pour connaître (par estimation et/ou mesure) l'énergie courante d'un équipement de test du demandeur (Computing Cube d'Orange). Cet équipement est un objet connecté tirant uniquement son énergie de fonctionnement de l'énergie solaire.

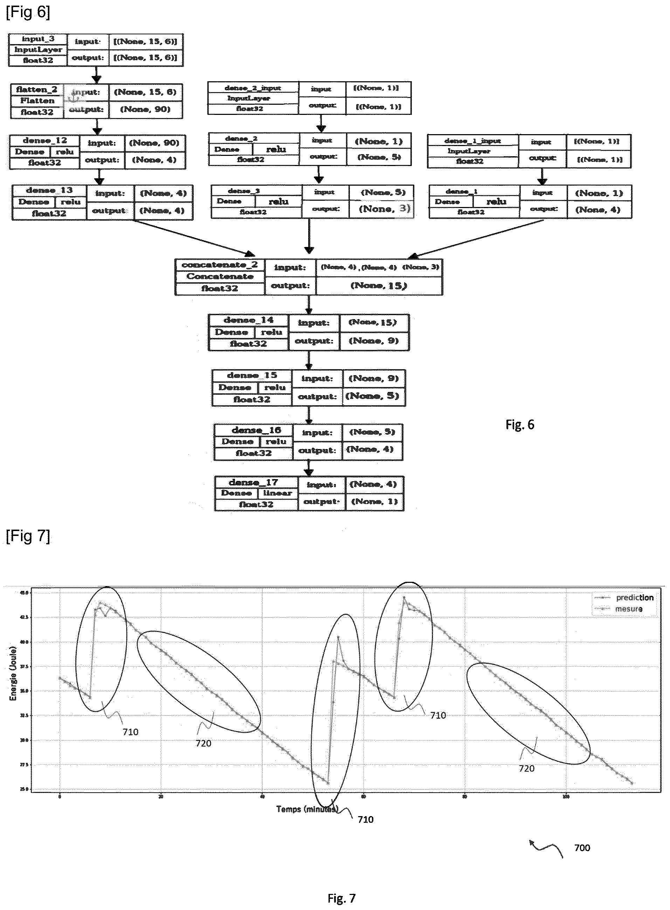

La construction du modèle de prédiction est effectuée sur un dispositif tiers. Le modèle de prédiction construit est le modèle illusté en figure 4 déjà introduite, où les données contextuelles d'entrées sont uniquement représentatives de l'environnement de l'équipement, ou en variante celui de la figure 6 où les données contextuelles d'entrée sont à la fois représentatives de l'environnement de l'équipement et de son activité. Dans cette mise en oeuvre, le modèle construit selon la figure 4 a une taille de 5 kilo-octets puis après élagage, de 3.6 kilo-octets tandis que le modèle construit selon la figure 4 a une taille de 7 kilo-octets puis après élagage, de 6,1 kilo-octets.

Le modèle sélectionné sur la base du modèle de la figure 4 est un modèle entraîné avec une fréquence de mesure de 30 minutes. La fréquence de mesure des données contextuelles est de 2 minutes.

Un gel des 2 dernières couches du modèle est effectué avant le transfert du modèle vers l'équipement de test.

Un entraînement local du modèle est effectué après transfert, en utilisant les 6 dernières mesures d'énergie effectuées, et les données contextuelles collectées correspondantes. Il peut aussi être effectué à nouveau, si l'écart entre l'énergie prédite et l'énergie mesurée est supérieur à 1% de la charge maximale de l'équipement (ici 0.4 Joules.) Dans ce cas, le réentraînement utilise les 2 dernières mesures d'énergie effectuées, et les données contextuelles collectées correspondantes.

La figure 7 présente les résultats de tests obtenus pour un objet de type Computing cube d'Orange. Les zones entourées par des cercles 710 montrent une augmentation brusque de l'énergie qui sont dûes à un changement brutal de l'environnement. Le modèle initial n'arrive pas à suivre immédiatement ces changements brusques donc un réentrainement du modèle sur l'objet est effectué. Le réentrainement dans ce cas peut être fait avec quelques données mesurées (énergie mesurée par l'INA + données environnementales issues des différents capteurs embarqués sur l'objet ou de capteurs tiers) (par exemple 2 données pour le modèle lié au Computing Cube). L'objet peut aussi réduire dynamiquement la fréquence de mesures des capteurs s'il trouve que le modèle est précis pour les n derniers points. Ce comportement est illustré par la zone entourée par un cercle 720.

Nous remarquons que le modèle s'aligne très bien avec les valeurs mesurées (les valeurs de prédictions et les valeurs réelles sont presque égales). Ainsi, il est inutile de mesurer réellement toutes les valeurs suivantes si le modèle peut les prédire finement. L'objet peut ainsi optimiser son énergie consommée.

L'algorithme 1 suivant peut par exemple être utilisé :
Algorithme de réduction dynamique de la fréquence de prise de mesure
Entrée : E_mesurée, E_prédite, F1
Sortie : F2
   1. Mesurer la valeur actuelle de l'énergie (E_mesurée) chaque F1
   2. Prédire la valeur actuelle de l'énergie avec le modèle (E_prédite) chaque F1
   3. Calculer l'écart (e) entre les 2 valeurs = | E_mesurée - E_prédite|
   4. Si e < seuil pour n fois consécutives
alors l'objet suppose que E_prédite = E_mesurée et saute x mesures => nouvelle fréquence de prise de mesure de l'INA (F2)=(x+1)*F1 (par exemple x=1 si l'objet décide de sauter une seule mesure)

Cette invention peut ainsi aider à étendre la durée de vie des objets en adaptant leur mode de fonctionnement à l'énergie disponible dans l'environnement ambiant et à l'énergie en stock dans leur batterie. Grâce à cela, les objets peuvent par exemple tomber moins souvent en panne d'énergie et/ou rester actifs plus longtemps.

## Revendications

1. Procédé de construction d'un modèle de prédiction de l'énergie courante d'un équipement électromécanique, ledit procédé comprenant :
- une construction d'une pluralité de modèles de prédiction à partir d'un modèle de prédiction initial, ladite pluralité de modèles de prédiction étant obtenue par une pluralité d'entraînements dudit modèle de prédiction initial tenant compte d'un historique de résultats de mesure de l'énergie courante dudit équipement associés à des données représentatives d'un contexte dudit équipement entre lesdites et /ou lors desdites mesures, lesdites mesures étant effectuées avec des fréquences différentes dans ladite pluralité d'entraînements ;
- une sélection d'un des modèles construits en tenant compte desdites fréquences et de précisions desdits modèles construits.

2. Dispositif électronique comprenant un moins un processeur configuré pour :
- une construction d'une pluralité de modèles de prédiction de l'énergie courante d'un équipement électromécanique, à partir d'un modèle de prédiction initial, ladite pluralité de modèles de prédiction étant obtenue par une pluralité d'entraînements dudit modèle de prédiction initial tenant compte d'un historique de résultats de mesure de l'énergie courante dudit équipement associés à des données représentatives d'un contexte dudit équipement entre lesdites et /ou lors desdites mesures, lesdites mesures étant effectuées avec des fréquences ou des pas de mesure différents dans ladite pluralité d'entraînements ;
- une sélection d'un des modèles construits en tenant compte desdits fréquences et/ou pas de mesure et de précisions desdits modèles construits.

3. Procédé selon la revendication 1 comprenant, ou dispositif électronique selon la revendication 2 où ledit processeur est configuré pour, une transmission à au moins un dispositif, de données caractérisant ledit modèle de prédiction sélectionné et/ou de la fréquence utilisée pour l'entraînement dudit modèle de prédiction sélectionné.

4. Procédé selon la revendication 1 ou 3 comprenant, ou dispositif électronique selon la revendication 2 ou 3 où ledit processeur est configuré pour, une transmission audit dispositif d'au moins une indication relative à au moins un type de données contextuelles utilisées pour l'entraînement dudit modèle de prédiction sélectionné.

5. Procédé de surveillance de l'énergie courante d'un équipement électromécanique, ledit procédé comprenant :
- une obtention d'un premier modèle de prédiction de ladite énergie courante dudit équipement, et d'une fréquence de mesure de ladite énergie ;
- une prédiction, via ledit modèle de prédiction, de l'énergie dudit équipement, en utilisant en entrée dudit modèle le résultat d'une première mesure de ladite énergie courante dudit équipement et des données représentatives d'un contexte dudit équipement lors de et/ou depuis la première mesure, ladite prédiction étant effectuée avant et/ou lors d'une seconde mesure ultérieure à ladite première mesure et effectuée en respectant ladite fréquence obtenue par rapport à ladite première mesure;
- une variation de la fréquence d'au moins une mesure de l'énergie dudit équipement, ultérieure à ladite seconde mesure, en fonction d'un écart entre ladite énergie prédite et ladite seconde mesure.

6. Dispositif électronique comprenant un moins un processeur configuré pour une surveillance de l'énergie courante d'un équipement électromécanique, ladite surveillance comprenant :
- une obtention d'un premier modèle de prédiction de ladite énergie courante dudit équipement, et/ou d'une fréquence de mesure de ladite énergie ;
- une prédiction, via ledit modèle de prédiction, de l'énergie dudit équipement, en utilisant en entrée dudit modèle le résultat d'une première mesure de ladite énergie courante dudit équipement et des données représentatives d'un contexte dudit équipement lors de et/ou depuis la première mesure, ladite prédiction étant effectuée avant et/ou lors d'une seconde mesure ultérieure à ladite première mesure et effectuée en respectant ladite fréquence obtenue par rapport à ladite première mesure;
- une variation de la fréquence d'au moins une mesure de l'énergie dudit équipement, ultérieure à ladite seconde mesure, en fonction d'un écart entre ladite énergie prédite et ladite seconde mesure.

7. Procédé selon la revendication 5 où le procédé comprend, ou dispositif électronique selon la revendication 6 où ledit processeur est configuré pour, une obtention d'au moins une indication relative à au moins un type de données contextuelles à utiliser pour ledit modèle de prédiction ; et où ladite obtention de données contextuelles tient compte de ladite indication obtenue.

8. Procédé selon la revendication 5 ou 7, ou dispositif électronique selon la revendication 6 ou 7, où l'obtention dudit modèle de prédiction et de ladite fréquence comprend :
- une construction d'une pluralité de modèles de prédiction à partir d'un modèle de prédiction initial, ladite pluralité de modèles de prédiction étant obtenue par une pluralité d'entraînements dudit modèle de prédiction initial tenant compte d'un historique de résultats de mesure de l'énergie courante dudit équipement associés à des données représentatives d'un contexte dudit équipement entre lesdites et /ou lors desdites mesures, lesdites mesures étant effectuées avec des fréquences différentes dans ladite pluralité d'entraînements ;
et où ledit modèle obtenu est sélectionné parmi lesdits modèles construits en tenant compte desdites fréquences et de précisions desdits modèles construits, ladite fréquence obtenue étant la fréquence utilisée pour l'entraînement dudit modèle de prédiction sélectionné.

9. Procédé selon l'une des revendications 1 ou 3 ou 4 ou 5 ou 7 ou 8, ou dispositif électronique selon l'une des revendications 2 à 4 ou 6 à 8, où le modèle sélectionné est le modèle de prédiction ayant la fréquence de mesure la plus faible et une précision supérieure à une première valeur.

10. Procédé selon l'une des revendications 1 ou 3 ou 4 ou 5 ou 7 à 8, ou dispositif électronique selon l'une des revendications 2 à 4 ou 6 à 8, où la sélection d'un modèle parmi lesdits modèles construits tient compte d'une capacité en énergie dudit équipement.

11. Procédé selon l'une des revendications 1 ou 3 ou 4 ou 5 ou 7 à 10, ou dispositif électronique selon l'une des revendications 2 à 4 ou 6 à 10, comprenant un élagage d'au moins un poids d'au moins un réseau de neurones d'au moins un modèle de prédiction construit et/ou dudit modèle de prédiction sélectionné.

12. Procédé selon l'une des revendications 1 ou 3 ou 4 ou 5 ou 7 à 11 comprenant, ou dispositif électronique selon l'une des revendications 2 à 4 ou 6 à 11 où ledit processeur est configuré pour, un gel d'au moins une couche d'au moins un réseau de neurones d'au moins un modèle de prédiction construit et/ou dudit modèle de prédiction sélectionné.

13. Programme d'ordinateur comprenant des instructions pour la mise en oeuvre, lorsque ledit programme est exécuté par un processeur d'un dispositif électronique, d'un procédé comprenant:
- une construction d'une pluralité de modèles de prédiction à partir d'un modèle de prédiction initial, ladite pluralité de modèles de prédiction étant obtenue par une pluralité d'entraînements dudit modèle de prédiction initial tenant compte d'un historique de résultats de mesure de l'énergie courante dudit équipement associés à des données représentatives d'un contexte dudit équipement entre lesdites et /ou lors desdites mesures, lesdites mesures étant effectuées avec des fréquences ou des pas de mesure différents dans ladite pluralité d'entraînements ;
- une sélection d'un des modèles construits en tenant compte desdits fréquences et/ou pas de mesure et de précisions desdits modèles construits.

14. Programme d'ordinateur comprenant des instructions pour la mise en oeuvre, lorsque ledit programme est exécuté par un processeur d'un dispositif électronique, d'un procédé de surveillance de l'énergie courante d'un équipement électromécanique, ledit procédé comprenant :
- une obtention d'un premier modèle de prédiction de ladite énergie courante dudit équipement, et/ou d'une fréquence de mesure et/ou d'un pas de mesure de ladite énergie ;
- une prédiction, via ledit modèle de prédiction, de l'énergie dudit équipement, en utilisant en entrée dudit modèle le résultat d'une première mesure de ladite énergie courante dudit équipement et des données représentatives d'un contexte dudit équipement lors de et/ou depuis la première mesure, ladite prédiction étant effectuée avant et/ou lors d'une seconde mesure ultérieure à ladite première mesure et effectuée en respectant ladite fréquence et/ou ledit pas de mesure obtenu par rapport à ladite première mesure;
- une variation de la fréquence et/ou du pas de mesure d'au moins une mesure de l'énergie dudit équipement, ultérieure à ladite seconde mesure, en fonction d'un écart entre ladite énergie prédite et ladite seconde mesure.

15. Support d'enregistrement lisible par un processeur d'un dispositif électronique et sur lequel est enregistré un programme d'ordinateur comprenant des instructions pour la mise en oeuvre, lorsque le programme est exécuté par le processeur, d'un procédé de construction selon l'une quelconque des revendications 1 ou 2 ou 4, ou d'un procédé surveillance de l'énergie courante d'un équipement électromécanique selon l'une quelconque des revendications 5 ou 7 à 11.
